# EUROPÄISCHE PATENTSCHRIFT

(11) **EP 1 393 514 B1**
(45) Veröffentlichungstag und Bekanntmachung des Hinweises auf die Patenterteilung: **23.08.2006**
(21) Anmeldenummer: 02748568.9
(22) Anmeldetag: 06.06.2002
(51) Int. Cl.: H04L 25/03, H04L 1/00

(54) **VERFAHREN UND SCHALTUNGSANORDNUNG ZUR ÜBERTRAGUNG VON DATEN ZWISCHEN EINEM PROZESSOR UND EINEM HARDWARE-RECHENWERK**
METHOD AND CIRCUIT FOR TRANSMITTING DATA BETWEEN A PROCESSOR AND A HARDWARE ARITHMETIC UNIT
PROCEDE ET CIRCUIT PERMETTANT LA TRANSMISSION DE DONNEES ENTRE UN PROCESSEUR ET UNE UNITE DE CALCUL MATERIELLE

(30) Priorität: 06.06.2001 DE 10127348
(43) Veröffentlichungstag der Anmeldung: 03.03.2004
(73) Patentinhaber: Infineon Technologies AG, 81669 München (DE)
(72) Erfinder: BECKER, Burkhard, 85737 Ismaning (DE)
(74) Vertreter: Lange, Thomas
(86) Internationale Anmeldenummer: PCT/DE2002/002063
(87) Internationale Veröffentlichungsnummer: WO 2002/100055

(56) Entgegenhaltungen:
- US-A- 5 537 445
- US-A- 5 539 780
- US-A- 5 905 757
- US-B1- 6 195 782

## Beschreibung

Die Erfindung betrifft ein Verfahren und eine Schaltung zur Übertragung von Daten zwischen einem Prozessor und einem einem Hardware-Rechenwerk, insbesondere Viterbi-Hardware-Rechenwerk.

In vielen Situationen der digitalen Datenübertragung müssen Daten bidirektional zwischen einem Prozessor und einer den Prozessor unterstützenden Hardware-Schaltung ausgetauscht werden. Dabei sind nicht selten die folgenden Gesichtspunkte von Bedeutung: Der vom Prozessor gesteuerte Datentransfer zwischen dem Prozessor und der Hardware-Schaltung darf auch bei hohen Datenraten keinen signifikanten Anteil (im Prozentbereich) an der verfügbaren Prozessorleistung in Anspruch nehmen. Darüber hinaus ist häufig eine schnelle Datenübertragung gefordert. Ein weiterer wichtiger Gesichtspunkt ist oftmals darin sehen, dass die Datenübertragung möglichst kompatibel mit unterschiedlichen Datenstrukturen (z.B. unterschiedliche Datentypen, Wortbreiten usw.) sein soll. Ferner werden für die Datenübertragung universelle Verfahren benötigt, d.h. Verfahren, welche auch für unterschiedliche konstruktive Ausführungen von Hardware-Schaltungen verwendbar sein sollen. Schließlich soll der Hardware-Aufwand zur Realisierung eines diesen Anforderungen gerecht werdenden Verfahrens gering gehalten werden.

Ein wichtiges Anwendungsgebiet, bei welchem sämtliche genannten Anforderungen zum Tragen kommen, ist der Bereich des Mobilfunks. In Mobilfunkempfängern werden sowohl zur Entzerrung der empfangenen Signale als auch zur Kanaldekodierung Berechnungsverfahren eingesetzt, die auf dem Viterbi-Algorithmus beruhen. Der Viterbi-Algorithmus ist ein Rekursionsverfahren, dessen Rechenabläufe sich Zeitschritt für Zeitschritt wiederholen. Insbesondere bei hohen Datenraten, bei Verwendung höherstufiger Modulationsverfahren, bei Zugrundelegung eines langen Kanalgedächtnisses bei der Entzerrung oder auch bei der Verwendung kleiner Koderaten bei der Kanalkodierung und in vielen anderen Situationen kann die Abarbeitung des Viterbi-Algorithmus sehr rechenaufwändig werden.

Die systemtechnisch einfachste Möglichkeit zur Durchführung des Viterbi-Algorithmus besteht darin, diesen allein von einem geeignet programmierten Prozessor ausführen zu lassen. Bei dieser Lösung ist jedoch nachteilig, dass leistungsstarke und somit teure Prozessoren benötigt werden, deren Rechenleistung in der Größenordnung von mindestens 400 MIPS (Million Instructions per Second) liegt. Hinzu kommt, dass solche Prozessoren einen hohen Stromverbrauch haben, weshalb sie in Mobiltelefonen aufgrund der dort beschränkten Energieressourcen praktisch nicht einsetzbar sind.

Es ist daher bereits vorgeschlagen worden, den Prozessor durch Hinzufügen einer Viterbi-Hardware-Schaltung zu entlasten. Insbesondere ist bereits bekannt, die rechenaufwändigen ACS-(Add-Compare-Select)-Operationen von einer derartigen Viterbi-Hardware-Schaltung durchführen zu lassen, d.h. aus dem Prozessor "auszulagern". Solche Hardware-Schaltungen werden in der Literatur häufig als Hardware-Unterstützungen (hardware supports) oder Hardware-Beschleuniger (hardware accelerators) bezeichnet.

In dem Buch "Halbleiterschaltungstechnik", von U. Tietze und Ch. Schenk, 10 Auflage, 1993, Springer Verlag, Berlin, ist auf den Seiten 284 und 285, Kapitel 11.2.2, der Betrieb eines RAMs als Schieberegister beschrieben. Dabei wird die Zugriffsadresse des Schieberegisters durch einen Zähler erzeugt.

In der Schrift EP 0 899 887 A2 ist ein Schaltkreis für einen Viterbi-Dekodierer mit geringer Leistungsaufnahme beschrieben. Der Schaltkreis besteht aus Arithmetik-Einheiten und Speichern zur Zwischenspeicherung von in den Arithmetik-Einheiten berechneten Zwischenergebnissen. Der Schrift sind keine Hinweise darauf zu entnehmen, wie dieser Schaltkreis mit einem DSP (digitaler Signalprozessor) zusammenwirkt bzw. von diesem programmiert wird.

Eine weitere Arithmetik-Einheit zur Durchführung einer Viterbi-Decodierung ist in der Schrift EP 0 590 597 A2 beschrieben. Von der Arithmetik-Einheit berechnete Zwischenergebnisse verschiedener Datentypen werden in dafür vorgesehenen Zwischenspeichern abgelegt. Dieser Schrift ist nichts in Bezug auf die Übertragung von Daten zwischen der Viterbi-Einheit und dem DSP zu entnehmen.

Aus der Druckschrift US 5,537,445 ist es bekannt, dass über eine indirekte Adressierung Daten zwischen einem Prozessor (DSP) und einem als Bestandteil eines Co-Prozessors realisierten Datenregisterbereich ausgetauscht werden können. Hierbei wird beim Schreiben auf das Datenregister eine Adresse in ein Adressenregister und das zugehörige Datum in ein Datenregister geladen. Die Adresse wird anschließend von einem Adress-Generator im Co-Prozessor in eine Adresse des Datenregisterbereiches übersetzt. Der Leseprozess erfolgt analog.

In der Druckschrift US 6,195,782 B1 ist ein Viterbi-Entzerrer für Mobilfunk-Anwendungen beschrieben, welcher einen DSP und ein Hardware-Modul umfasst. Ferner ist ein gemeinsamer Speicher zur Speicherung von Pfad- und Zweigmetriken vorgesehen, auf den sowohl der DSP als auch das Hardware-Modul über einen gemeinsamen Bus zugreifen. Zum sukzessiven Datenzugriff des Hardware-Moduls auf den gemeinsamen Speicher werden ausgehend von vom DSP bereitgestellten Start-Adressen im Hardware-Modul Zugriffsadressen mit Hilfe von Zählern generiert.

Der Erfindung liegt die Aufgabe zugrunde, ein Verfahren zur Übertragung von Daten zwischen einem digitalen Prozessor und einem Hardware-Rechenwerk, insbesondere Viterbi-Hardware-Rechenwerk, anzugeben, welches mit Blick auf die genannten Anforderungen mit Vorteil einsetzbar ist. Ferner zielt die Erfindung darauf ab, eine Schaltungsanordnung oder Schnittstelle mit diesen Eigenschaften für den Datenaustausch zwischen einem Prozessor und einem Hardware-Rechenwerk bereitzustellen.

Die der Erfindung zugrunde liegende Aufgabenstellung wird durch die Merkmale der unabhängigen Ansprüche gelöst.

Demnach geht die Erfindung von einem Hardware-Rechenwerk aus, welchem wenigstens ein Tabellenspeicher zugeordnet ist, wobei Daten mehrerer Datentypen (z.B. im Falle eines Viterbi-Rechenwerks Empfangssymbole, Kanalkoeffizienten, Soft-Output-Werte, Trace-Back-Datensymbole usw.) in dem Tabellenspeicher gespeichert werden sollen. Der Schreib- und/oder Lesezugriff des Prozessors auf den Tabellenspeicher umfasst dabei die Schritte der Anwahl einer Basisadresse, welche abhängig von dem Datentyp der zu übertragenden Daten ist, und des Zugreifens auf den Tabellenspeicher, indem ausgehend von der angewählten Basisadresse mehrere für Schreib- und/oder Lesezugriffe verwendete Adressen des Tabellenspeichers bei aufeinanderfolgenden Zugriffen nach einer vorgegebenen arithmetischen Rechenvorschrift in Hardware berechnet werden.

Durch die Zuordnung von Basisadressen zu Datentypen wird erreicht, dass der Tabellenspeicher so partitioniert wird, dass Daten unterschiedlicher Datentypen in unterschiedlichen Speicherteilbereichen abgelegt werden. Bei einem Zugriff des digitalen Prozessors auf den Tabellenspeicher wird der für den entsprechenden Datentyp reservierte Speicherteilbereich über die Anwahl seiner Basisadresse adressiert. Da bei den anschließenden Speicherzugriffen die Adressierung über die Berechnung der Adressen in Hardware erfolgt, ist diese schnell und ohne Rechenaufwand für den Prozessor auszuführen.

Es wird darauf hingewiesen, dass die Erfindung die Übertragung von Daten zwischen dem digitalen Prozessor und dem Hardware-Rechenwerk, nicht jedoch die internen Zugriffe des Hardware-Rechenwerks auf den Tabellenspeicher betrifft. Das Zusammenwirken zwischen dem Hardware-Rechenwerk und dem Tabellenspeicher (d.h. die Zugriffssteuerung des Hardware-Rechenwerks auf den Tabellenspeicher) ist abhängig von der Implementierung bzw. dem durch die Implementierung vorgegebenen Algorithmus des Hardware-Rechenwerks und ist für die Erfindung nicht von Bedeutung.

Vorzugsweise ist die arithmetische Rechenvorschrift zur Berechnung der Adressen des Tabellenspeichers eine Inkrementierungs- bzw. Dekrementierungsvorschrift. Der Tabellenspeicher wird in diesem Fall in jedem der Speicherteilbereiche in Art eines Schieberegisters oder FIFOs betrieben, wobei im Unterschied zu einem üblichen Schieberegister hier nicht die Daten geschoben, sondern die Adresse, die als Zeiger auf die feststehenden Daten wirkt, durchgezählt wird.

Vorzugsweise sind die den unterschiedlichen Datentypen zugeordneten Basisadressen in einem Basisadressenregister abgelegt, wobei die Anwahl einer Basisadresse durch Setzen eines dieser Basisadresse zugeordneten Auswahlbits über den Prozessor erfolgt. Somit springt der Adressenzeiger automatisch auf die voreingestellte Basisadresse, sobald der Prozessor das entsprechende Auswahlbit setzt. In diesem Fall entfällt für den Prozessor auch der Aufwand für die Erzeugung von Basisadressen.

Nach einer ersten bevorzugten Verfahrensvariante sind die Basisadressen unveränderbar bzw. fest verdrahtet in Hardware vorgegeben. Damit liegt der Tabellenspeicher in fest vorgegebener Konfiguration vor.

Eine alternative Ausführungsvariante des erfindungsgemäßen Verfahrens kennzeichnet sich dadurch, dass die Basisadressen von dem digitalen Prozessor programmierbar sind. In diesem Fall ist die Möglichkeit einer flexiblen Programmierung der das Hardware-Rechenwerk und den Tabellenspeicher umfassenden Hardware-Unterstützung durch den Prozessor gegeben, was insbesondere bei der Verwendung unterschiedlicher Mobilfunkstandards oder Modulationsverfahren von Vorteil sein kann.

Im Falle einer flexiblen Programmierbarkeit der Hardware-Unterstützung durch den digitalen Prozessor ist vorzugsweise vorgesehen, dass eine Information betreffend die Anzahl der Daten, die in die den jeweiligen Basisadressen (BA0, BA1, ..., BAn) zugeordneten Speicherteilbereiche (T1_RAM1, ..., T0_RAM2, ..., T0_RAMW1, ..., T0_RAMW2) geschrieben oder aus diesen gelesen werden und/oder und/oder eine Information über die Blockgröße von Datenblöcken und/oder eine Information über die Dekodierrate und/oder eine Information über die bei der Kanalkodierung verwendeten Faltungspolynome von dem digitalen Prozessor programmierbar sind. Auf diese Weise kann das Hardware-Rechenwerk davon unterrichtet werden, wie die von dem Prozessor in den Tabellenspeicher geschriebenen Daten zu verwenden oder zu prozessieren sind.

Eine weitere vorteilhaft Maßnahme des erfindungsgemäßen Verfahrens kennzeichnet sich durch die Wahl eines Packungsmodus, welcher bewirkt, dass mehrere von dem Prozessor ausgegebene Datenwörter für einen Schreibzugriff zu einem "gepackten" Speicherdatenwort für den Tabellenspeicher zusammengefasst werden, und/oder durch die Wahl eines Entpackungsmodus, welcher bewirkt, dass ein mit einem Lesezugriff aus dem Tabellenspeicher gelesenes Speicherdatenwort vor der Eingabe in den Prozessor in mehrere Datenwörter zerlegt wird. Auf diese Weise kann eine Anpassung der Wortbreite des spezifischen Datentyps an die vorgegebene Wortbreite des Tabellenspeichers erreicht werden, d.h. z.B. können bei einem Datentyp kleinerer Wortbreite mehrere Wörter pro Speicheradresse im Tabellenspeicher untergebracht werden. Damit wird einerseits eine bessere Speicherplatznutzung ermöglicht und es wird andererseits - sofern gewünscht - ein Vielfachzugriff seitens der Hardware-Schaltung auf mehrere Datenwörter unterstützt. Der Entpackungsmodus erlaubt, "gepackte" Speicherdatenwörter wieder in die ursprünglichen Datenwörter aufzutrennen, so dass der Prozessor (welcher eine fest vorgegebene Eingangs-Wortbreite aufweist) die Datenwörter verarbeiten kann. Das Packen bzw. Entpacken der Datenwörter kann wiederum ohne Beteiligung des Prozessors erfolgen.

Ein wichtiger Anwendungsbereich der vorliegenden Erfindung kennzeichnet sich dadurch, dass es sich bei dem Rechenwerk um ein Viterbi-Hardware-Rechenwerk (z.B. für die Kanaldekodierung oder für die Entzerrung) handelt.

Eine erfindungsgemäße Schaltungsanordnung zur Übertragung von Daten mehrerer Datentypen zwischen dem Prozessor und dem Hardware-Rechenwerk sieht einen Eingabe- und/oder Ausgabespeicher vor, auf welchen der Prozessor für die Dateneingabe/-ausgabe mit vorgegebener Adresse zugreift. Durch die bereits im Zusammenhang mit dem erfindungsgemäßen Verfahren beschriebenen Maßnahmen werden mittels eines Basisadressen-Speichermittels (welches insbesondere ein außerhalb des Prozessors angeordnetes Basisadressenregister ist) und einer Hardware-Adressenberechnungsschaltung, welche insbesondere ein Zählmittel ist, ohne Beteiligung des Prozessors die Zugriffsadresse für den Tabellenspeicher generiert. Das in dem Eingabe- und/oder Ausgabespeicher befindliche Datenwort wird dann unter dieser Adresse im Tabellenspeicher abgespeichert. Das Verfahren ermöglicht eine hohe Datenrate, da der Prozessor auf den Eingabe- und/oder Ausgabespeicher ohne Wartezyklen, d.h. im Systemtakt, zugreifen kann.

Es wird darauf hingewiesen, dass über den Eingabe- und/oder Ausgabespeicher mit lediglich einer einzigen festen Adresse sämtliche Hardware-Speicherteilbereiche beschrieben oder gelesen werden können, ohne dass hierfür eine Vielzahl von internen Adressen im Prozessor berechnet werden müssen. Sofern zwei Hardware-Rechenwerke (eines für die Entzerrung und eines für die Kanaldekodierung) vorgesehen sind, sind vorzugsweise zwei Eingabe- und/oder Ausgabespeicher vorhanden, d.h. für die Zugriffe des Prozessors auf die gesamte Entzerrer- und Dekodierer-Hardware werden nur zwei dem Prozessor bekannte feste Adressen benötigt.

Im Falle der flexiblen Programmierung der Hardware kennzeichnet sich eine vorteilhafte Ausführungsvariante der erfindungsgemäßen Schaltungsanordnung durch einen Konfigurationsspeicher, in welchem eine Information über die Anzahl der Daten, die in die den jeweiligen Basisadressen zugeordneten Speicherteilbereiche geschrieben oder aus diesen gelesen werden und/oder eine Information über die Blockgröße von Datenblöcken und/oder eine Information über die Dekodierrate und/oder eine Information über die bei der Kanalkodierung verwendeten Faltungspolynome gespeichert sind. Durch diese Konfigurationsdaten wird dem Hardware-Rechenwerk die Zuordnung und Verwendung der Daten mitgeteilt, die von dem digitalen Prozessor in die den jeweiligen Basisadressen zugeordneten Speicherteilbereiche geschriebenen werden bzw. die von dem digitalen Prozessor aus den den jeweiligen Basisadressen zugeordneten Speicherteilbereiche gelesen werden.

Die Erfindung wird nachfolgend unter Bezugnahme auf die Zeichnung anhand von Beispielen aus dem Bereich der Mobilfunktechnik näher erläutert; in dieser zeigt:
- Fig. 1: eine Schaltung zur Durchführung von Viterbi-Berechnungen in Form von Funktionsblöcken, zur Erläuterung des generellen Aufbaus einer solchen Schaltung;
- Fig. 2: ein schematisches Schaltbild einer erfindungsgemäßen Schaltungsanordnung;
- Fig. 3: ein Blockschaltbild, welches die Architektur einer Entzerrer- und Kanaldekodierer-Schaltung zeigt, welche eine erfindungsgemäße Schaltungsanordung einsetzt;
- Fig. 4: eine schematische Darstellung einer Speicherpartition für die in Fig. 3 dargestellte Entzerrer- und Kanaldekodierer-Schaltung; und
- Fig. 5: eine schematische Darstellung einer Variante der erfindungsgemäßen Schaltungsanordnung zur Erläuterung des Packens von Datenwörtern bzw. Entpackens von Speicherdatenwörtern.

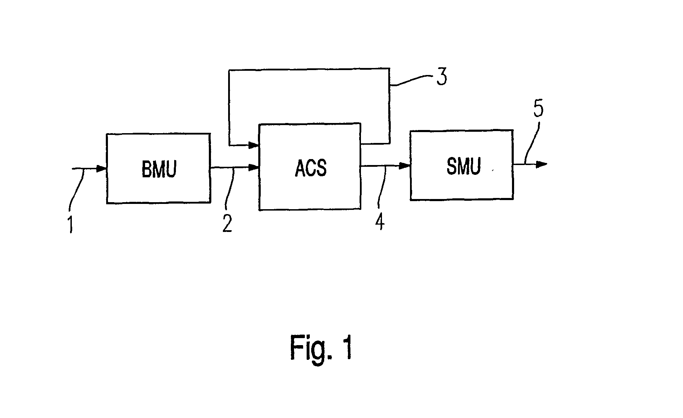

Fig. 1 zeigt den generellen Aufbau einer Viterbi-Berechnungseinheit bestehend aus einer Einheit zur Berechnung von Übergangsmetriken BMU (Branch Metric Unit), einer Einheit zur Durchführung von ACS-Operationen, ACS, und einer Einheit zur Durchführung von Trace-Back-Operationen bezüglich der ermittelten Pfade SMU (Survivor Memory Unit). Eine Viterbi-Berechnungseinheit der gezeigten Struktur wird sowohl in Entzerrern (Datendetektoren) als auch in Kanaldekodierern eingesetzt.

Die generelle Funktionsweise von Viterbi-Berechnungseinheiten ist bekannt und wird hier lediglich kurz erläutert:

Allgemein liegt der Viterbi-Berechnung die Idee zugrunde, durch ein rekursives Verfahren einen kürzesten Weg durch ein Zustandsdiagramm (sogenanntes Trellis-Diagramm) zu ermitteln, in welchem die Zustände eines Schieberegisters über der Zeit aufgetragen sind. Im Falle der Entzerrung repräsentiert das Schieberegister das Kanalgedächtnis, während im Falle der Kanaldekodierung das Schieberegister des Kanalkodierers betrachtet wird. In beiden Fällen wird pro Zeitschritt eine Dateneinheit (beim Entzerrer: ein Datensymbol; beim Kodierer: ein Bit) in das entsprechende Schieberegister eingeschoben und dadurch der Zustand des Schieberegisters verändert. Die Werte der Dateneinheiten, die dem jeweiligen Schieberegister in jedem Zeitschritt zugeführt werden, kommen als mögliche Empfangswerte in Frage. Die Wahrscheinlichkeit für das Auftreten dieser Dateneinheiten als Empfangswerte wird mittels der Viterbi-Rekursion Zeitschritt für Zeitschritt bestimmt. Dabei berechnet die Einheit BMU für jeden möglichen Übergang im (Kanalkodierer- bzw. Entzerrer-)Trellis-Diagramm Übergangswahrscheinlichkeiten, die als Übergangsmetrikwerte bezeichnet werden. Die Berechnung dieser Übergangsmetrikwerte beruht auf der dem Empfänger aktuell zur Verfügung stehenden Information, d.h. im Falle der Entzerrung auf den empfangenen Datensymbolen und den von einem Kanalschätzer ermittelten Kanalparametern, und im Falle der Kanaldekodierung auf den von dem Entzerrer ausgegebenen Soft-Output-Werten.

Die in der Einheit BMU zur Berechnung der Übergangsmetriken berechneten Übergangsmetrikwerte werden über die Datenverbindung 2 der ACS-Einheit zugeführt. In der ACS-Einheit werden die Übergangsmetrikwerte den jeweiligen Zustandsmetriken der Vorgänger-Zustände hinzuaddiert (sogenannte "ADD"-Operation), und es werden die auf diese Weise erhaltenen Summen verglichen (sogenannte "COMPARE"-Operation). Derjenige Übergang, dessen Summe aus Übergangsmetrikwert und Metrik des Vorgänger-Zustands minimal ist, wird ausgewählt (sogenannte "SELECT"-Operation) und bildet die Verlängerung des in den Vorgänger-Zustand mündenden Pfades in den Zielzustand. Diese drei Operationen werden als ACS-Operationen bezeichnet und von der ACS-Einheit ausgeführt.

Sowohl bei der Viterbi-Entzerrung als auch bei der Viterbi-Dekodierung wird der ACS-Schritt innerhalb jedes Zeitschrittes zyklisch ausgeführt, wie dies durch die Schleife 3 in Fig. 1 angedeutet ist. Bei jedem Zyklus wird die ACS-Operation für eine bestimmte Gruppe von Vorgänger-Zuständen und Zielzuständen abgearbeitet, welche als "Butterfly" bezeichnet wird.

Nachdem für einen bestimmten Zeitschritt im Trellis-Diagramm sämtliche Metriken bestimmt sind, werden die zugehörigen Zustandsübergänge der Einheit SMU über die Datenverbindung 4 mitgeteilt. Die Einheit SMU führt eine Trace-Back-Operation zur Ermittlung eines um eine bestimmte Anzahl von Zeitschritten zurückliegenden Datenbits (Kanaldekodierung) bzw. Datensymbols (Entzerrung) durch. Der Trace-Back-Operation liegt zugrunde, dass im Trellis-Diagramm die einzelnen Pfade in zeitlicher Rückwärtsrichtung konvergieren, d.h., dass Datenbits/Datensymbole, die für einen länger zurückliegenden Übergang ermittelt wurden, für überlebende Pfade eine höhere Sicherheit aufweisen (ob ein Pfad überlebt oder nicht, stellt sich eben erst nach Abarbeitung einer bestimmten Anzahl weiterer Zeitschritte heraus).

Im Falle der Kanaldekodierung gibt die Einheit SMU über die Datenverbindung 5 dekodierte Datenbits aus. Im Falle der Entzerrung werden über die Datenverbindung 5 Soft-Output-Werte und Hard-Output-Werte bereitgestellt.

Die anhand Fig. 1 erläuterten Rechenschritte werden teilweise in Hardware und teilweise von einem Prozessor mittels Software (Firmware) ausgeführt. Dies macht Schnittstellen zwischen der Hardware und dem Prozessor erforderlich. Je nach konstruktiver Auslegung und Anforderungen können Schnittstellen bei sämtlichen der in Fig. 1 dargestellten Datenverbindungen 1, 2, 3, 4, 5 und darüber hinaus auch an anderer Stelle bestehen.

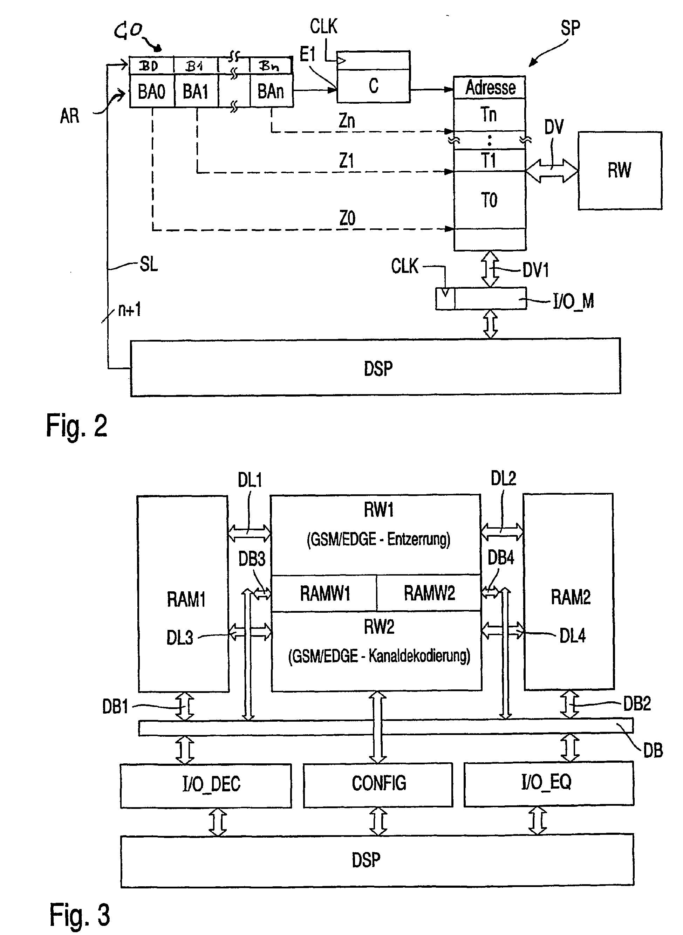

Fig. 2 verdeutlicht anhand eines Beispiels den Aufbau einer erfindungsgemäßen Schnittstelle sowie den Ablauf einer Datenübergabe zwischen einem digitalen Signalprozessor DSP und einem Viterbi-Rechenwerk RW.

Das in Form von festverdrahteter Hardware ausgeführte Viterbi-Rechenwerk RW steht über eine bidirektionale Datenverbindung DV mit dem Dateneingang/Ausgang eines Tabellenspeichers SP in Verbindung. Ferner steht der Dateneingang/Ausgang des Tabellenspeichers SP über eine weitere Datenverbindung DV1 mit dem Dateneingang/Ausgang eines Eingabe/Ausgabespeichers I/O_M in Datenaustauschverbindung. Der Eingabe/Ausgabespeicher I/O_M ist dem DSP zugeordnet und von diesem über eine fest vorgegebene Adresse ansprechbar. Die Wortbreite des Eingabe/Ausgabespeichers I/O_M entspricht der Wortbreite des DSP, z.B. 16 Bit.

Der Tabellenspeicher SP weist ebenfalls eine feste Wortbreite auf, die beispielsweise identisch mit der Wortbreite des Eingabe/Ausgabespeichers I/O_M sein kann. Der Adressdekoder des Tabellenspeichers SP wird über einen Zähler C angesteuert. Der Zähler C weist einen Setzeingang E1 auf, über welchen der Zählwert eingestellt werden kann. Die Taktung des Zählers C erfolgt mit dem Systemtakt CLK.

Der Setzeingang E1 des Zählers C ist mit dem Ausgang eines Basisadressenregisters AR verbunden. In dem Basisadressenregister AR sind mehrere Basisadressen BA0, BA1, .., BAn abgelegt. Zur Ansteuerung des Basisadressenregisters AR ist eine Steuerleitung SL mit einer Wortbreite n+1 vorgesehen. Über die Steuerleitung SL ist es dem DSP möglich, durch Setzen eines jeweiligen Auswahlbits B0, B1, ..., Bn eines Steuerregisters CO gezielt eine der in dem Basisadressenregister AR abgespeicherten n+1 Basisadressen BA0, BA1, .., BAn anzuwählen und damit dem Setzeingang E1 des Zählers C zuzuleiten. Die Basisadressen BA0, BA1, .., BAn sind vordefinierte Adressen des Tabellenspeichers SP, welche eine funktionale Partitionierung des Speicherteilbereichs des Tabellenspeichers SP in verschiedene Teilbereiche T0, T1, .., Tn vorgeben.

Die Basisadressen BA0, BA1, ..., BAn sind entweder durch Festverdrahtung fest vorgegeben oder können bei flexibler Konfigurierbarkeit des Tabellenspeichers SP direkt von dem DSP programmiert und dadurch geändert werden.

Im Folgenden wird die Wirkungsweise der erläuterten Schnittstelle für das Beispiel eines Viterbi-Entzerrers erläutert. Dabei soll (ebenfalls lediglich zu Erläuterungszwecken) die Schnittstelle zwischen dem DSP und dem Viterbi-Rechenwerk RW bei den Datenverbindungen 1, 5 angeordnet sein.

In diesem Fall führt das Viterbi-Rechenwerk RW die Berechnung der Übergangsmetriken, der ACS-Operationen und der Trace-Back-Operationen aus. Die folgenden Datentypen müssen vor bzw. nach einem Rechenlauf des Viterbi-Rechenwerks RW zwischen dem DSP und dem Viterbi-Rechenwerk RW übertragen werden.

### 1. Eingabedaten für das Viterbi-Rechenwerk RW:

- Empfangssymbole xₖ (k bezeichnet den Zeitschritt)
- Kanalkoeffizienten h₀, .., hₘ; oder Produkte der Kanalkoeffizienten und der Werte des Symbolalphabets; oder Teilsummen solcher Produkte (m bezeichnet die Länge des Kanalgedächtnisses)
- Initialisierungswerte für Zustandsmetriken und Zustandsvektoren

### 2. Ausgabedaten des Viterbi-Rechenwerks RW:

- Hard-Output-Werte (d.h. die Trace-Back-Werte)
- Soft-Output-Werte

In einem ersten Schritt werden die Eingabe-Datenwerte von dem DSP in den Tabellenspeicher SP geladen. Für jeden Datentyp wird ein Speicherteilbereich verwendet. Zum Beispiel werden zunächst die Empfangssymbole xₖ in den Speicherteilbereich T0 geschrieben. Zu diesem Zweck teilt der DSP dem Basisadressenregister AR durch Setzen des entsprechenden Auswahlbits B0 mit, dass der Datentyp "Empfangsdatensymbole" übertragen werden soll. Diesem Datentyp ist die Basisadresse BA0 zugeordnet. Das Setzen des entsprechenden Auswahlbits B0 bewirkt, dass der Adressenzeiger auf die in Fig. 2 dargestellte Position Z0 springt.

In einem nächsten Befehlsschritt wird der Systemtakt CLK an den Takteingang des Zählers C angelegt und gleichzeitig die Empfangssymbole xₖ im Systemtakt von dem DSP in den Eingabe/Ausgabespeicher I/O_M befördert. Das Schreiben der Empfangssymbole xₖ in den Eingabe/Ausgabespeicher erfolgt ohne Wartezustände bei Verwendung der stets gleichen, vorgegebenen Adresse des Eingabe/Ausgabespeichers I/O_M.

Die Adressenberechnung durch den Zähler C wird also allein bei einem Zugriff des DSP auf den Eingabe/Ausgabespeicher I/O_M aktiviert.

Das in den Eingabe/Ausgabespeicher I/O_M zwischengespeicherte Datenwort wird über die Datenverbindung DV1 unter der angewählten Adresse in den Tabellenspeicher SP geschrieben. Sofern kein Packungsmodus gewählt wird (beispielsweise kann dies bei identischer Wortbreite des Tabellenspeichers SP und des Datenworts der Fall sein), wird in jedem Systemtakt CLK genau ein Datenwort abgespeichert.

Durch die Partitionierung des Tabellenspeichers SP ist die Maximalanzahl der in einem Rechenlauf abzuspeichernden Datenwörter jedes Datentyps vorgegeben. Nach Abspeicherung der Empfangssymbole xₖ in dem Tabellenspeicher SP wird zu dem nächsten Datentyp gewechselt, indem der DSP über die Steuerleitung SL durch Setzen des entsprechenden Auswahlbits die nächste Basisadresse, z.B. BA1, anwählt. Der Adressenzeiger springt daraufhin auf die Position Z1 (d.h. die unterste Adresse in dem Speicherteilbereich T1) und die Datenübertragung vom DSP in den Tabellenspeicher SP wird für den zweiten Datentyp in gleicher Weise fortgeführt.

Sobald sämtliche, für einen Rechenlauf des Viterbi-Rechenwerks RW benötigten Datenwörter in den Tabellenspeicher SP eingetragen sind, d.h. dieser fertig "aufgeladen" ist, beginnt das Viterbi-Rechenwerk RW mit der Abarbeitung der entsprechenden Rechenoperationen. Das Rechenwerk RW ist in sequentieller Logik realisiert und ermöglicht daher eine schnelle und energiesparende Durchführung der Rechenschritte. Während des Rechenlaufs werden ständig für die Rechnung benötigte Daten aus den einzelnen Speicherteilbereichen abgerufen und Ergebnisdaten in hierfür vorgesehene, weitere Speicherteilbereiche (z.B. T2 bis Tn) des Tabellenspeichers SP geschrieben. Diese Zugriffsschritte sind nicht zeitkritisch, da sie parallel mit der Abarbeitung von Rechenschritten im Rechenwerk RW vorgenommen werden.

Nach Beendigung des sich vorzugsweise über eine Vielzahl von Zeitschritten k erstreckenden Rechenlaufs sind sämtliche Eingabedaten prozessiert und die entsprechenden Ausgabedaten (Hard-Output-Werte und Soft-Output-Werte) in den Tabellenspeicher SP geschrieben. Das Viterbi-Rechenwerk RW geht in einen Wartezustand über, in welchem die Ergebnisdaten schnellstmöglich von dem DSP aus dem Tabellenspeicher SP ausgelesen werden müssen. Das Auslesen von Daten aus dem Tabellenspeicher SP erfolgt in gleicher Weise wie das Schreiben von Daten in den Tabellenspeicher SP. Der Zugriff des DSP erfolgt allein auf den Eingabe/Ausgabespeicher I/O_M und wird auf das durch die Basisadresse und die Anzahl der bereits erfolgten Zugriffe definierte Speicherdatenwort im Tabellenspeicher SP umgeleitet.

Der Wechsel der Speicherteilbereiche wird wiederum durch Anwahl eines anderen Basisadressen-Auswahlbits bewerkstelligt.

Der Eingabe/Ausgabespeicher I/O_M kann ein Prozessor-internes sogenanntes benutzerdefiniertes Register ("user-defined register") sein. Wichtig ist, dass der Zugriff des DSP auf dieses Register ohne Wartezustände und mit fester Adresse erfolgen kann.

Fig. 3 zeigt die Architektur einer Empfängerschaltung mit einem Entzerrer und einem Kanaldekodierer, welche einen digitalen Signalprozessor DSP und eine mit dem DSP über eine erfindungsgemäße Schnittstelle in Verbindung stehende Hardware-Unterstützung für die Entzerrung und die Dekodierung einsetzt. Der DSP ist über ein oder mehrere Konfigurationsregister CONFIG mit zwei Viterbi-Rechenwerken RW1 und RW2 verbunden. Das erste Rechenwerk RW1 dient der Entzerrung des empfangenen Datensignals, das zweite Rechenwerk RW2 führt eine Kanaldekodierung durch. Die Rechenwerke RW1 und RW2 können eine Entzerrung bzw. Kanaldekodierung sowohl z.B. gemäß dem GSM-(Global System for Mobile Communications-)Standard als auch gemäß dem EDGE-(Enhanced Data Services for GSM Evolution-)Standard ausführen.

Das erste Rechenwerk RW1 steht über eine erste bidirektionale Datenverbindung DL1 mit einem ersten flüchtigen Datenspeicher RAM1 und über eine zweite bidirektionale Datenverbindung DL2 mit einem zweiten flüchtigen Datenspeicher RAM2 in Datenaustauschverbindung. Entsprechende dritte und vierte bidirektionale Datenverbindungen DL3 und DL4 sind zwischen dem zweiten Rechenwerk RW2 und dem ersten Datenspeicher RAM1 sowie dem zweiten Rechenwerk RW2 und dem zweiten Datenspeicher RAM2 vorgesehen.

Beide Rechenwerke RW1 und RW2 können ferner auf zwei flüchtige Datenspeicher RAMW1 und RAMW2 zugreifen. Wie noch näher erläutert wird, werden in den Datenspeichern RAMW1 und RAMW2 Zwischenergebniswerte abgelegt, die bei der Entzerrung und/oder der Kanaldekodierung in den Rechenwerken RW1 und RW2 anfallen.

Der DSP kann auf sämtliche der genannten Datenspeicher RAM1, RAM2, RAMW1, RAMW2 über Datenbusse DB1, DB2, DB3 bzw. DB4, welche mit einem zentralen Datenbus DB in Verbindung stehen, zugreifen. Jeder Datenspeicher RAM1, RAM2, RAMW1, RAMW2 entspricht daher dem in Fig. 2 gezeigten Tabellenspeicher SP, die Datenbusse DB1, DB2, DB3 bzw. DB4 sind jeweils mit der Datenverbindung DV1 in Fig. 2 vergleichbar. Der Zugriff des DSP erfolgt über zwei getrennte Eingabe/Ausgabespeicher I/O_DEC und I/O_EQ. Diese beiden Speicher entsprechen dem in Fig. 2 mit dem Bezugszeichen I/O_M bezeichneten Eingabe/Ausgabespeicher. Für den Zugriff des DSP während eines Kanaldekodiervorgangs wird der Eingabe/Ausgabespeicher I/O_DEC eingesetzt, während für den Zugriff des DSP während eines Entzerrungsvorgangs der Eingabe/Ausgabespeicher I/O_EQ eingesetzt wird. Auf diese Weise ist es möglich, mit einem Prozessor gleichzeitig eine Hardware-unterstützte Entzerrung und eine Hardware-unterstützte Kanaldekodierung zu bewerkstelligen. Ferner werden mit lediglich zwei Adressen (nämlich für den Eingabe/Ausgabespeicher I/O_DEC und für den Eingabe/Ausgabespeicher I/O_EQ) sämtliche Hardware-Speicherteilbereiche für die Anwendungen Viterbi-Decoder und Viterbi-Entzerrer beschrieben und gelesen.

Das Steuerregister CO kann als Teil des Konfigurationsregisters CONFIG im externen Speicherbereich des DSP angeordnet sein. Das dem Steuerregister CO zugeordnete Basisadressenregister AR ist ebenfalls im externen Speicherbereich des DSP lokalisiert und wurde in Fig. 3 weggelassen. Die Ansteuerung der Datenspeicher RAM1, RAM2, RAMW1 und RAMW2 über zugehörige Zähler C entspricht der Darstellung in Fig. 2 und ist in Fig. 3 ebenfalls weggelassen.

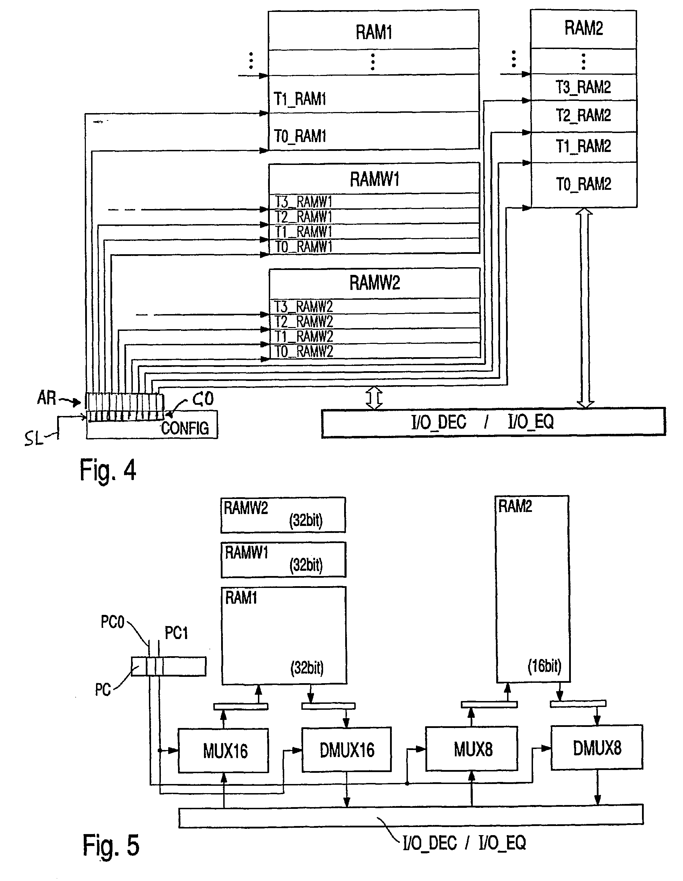

Nach Fig. 4 können die Datenspeicher RAM1, RAM2, RAMW1 und RAMW2 mittels des (festverdrahteten oder über den DSP programmierbaren) Basisadressenregisters AR in folgende Speicherteilbereiche partitioniert sein:

### RAM1 (32 Bit Wortbreite):

| | |
|---|---|
| T0_RAM1 | Empfangsdatensymbole xₖ (komplexwertig) |
| T1_RAM1 | Kanalkoeffizienten (komplexwertig) oder Produkte/Teilsummen für Übergangsmetrikwerte |

### RAM2 (16 Bit Wortbreite):

| | |
|---|---|
| T0_RAM2 | Trace-Back-Werte vom Dekodierer |
| T1_RAM2 | Soft-Input-Werte für Dekodierer |
| T2_RAM2 | Soft-Output-Werte vom Entzerrer |
| T3_RAM2 | Hard-Output-Werte vom Entzerrer |

### Datenspeicher RAMW1 (32 Bit Wortbreite):

| | |
|---|---|
| T0_RAMW1 | Metriken der Vorgängerzustände, Dekodierer |
| T1_RAMW1 | Metriken der Vorgängerzustände, Entzerrer |
| T2_RAMW1 | Pfade zu Vorgängerzuständen, Entzerrer |
| T3_RAMW1 | Übergangsmetrikwerte für vorausgegangenen Zeitschritt, Entzerrer |

### Datenspeicher RAMW2 (32 Bit Wortbreite):

| | |
|---|---|
| T0_RAMW2 | Metriken für Zielzustände, Dekodierer |
| T1_RAMW2 | Metriken für Zielzustände, Entzerrer |
| T2_RAMW2 | Pfade zu Zielzuständen, Entzerrer |
| T3_RAMW2 | Übergangsmetrikwerte zum aktuellen Zeitschritt, Entzerrer |

Es wird deutlich, dass, wie bereits erwähnt, auch die in den Datenspeichern RAMW1 und RAMW2 abgelegten temporären Werte von dem DSP adressierbar sind. Dies erlaubt die Unterbrechung eines Rechenlaufs (Dekodierung und/oder Entzerrung) durch einen anderen Prozess und die Fortführung des unterbrochenen Rechenlaufs nach Beendigung des unterbrechenden Prozesses.

Neben dem Steuerregister CO zur Anwahl der Basisadressen kann das Konfigurationsregister CONFIG weitere Konfigurationsinformationen für die Konfigurierung der Hardware-Rechenwerke RW1 und RW2 enthalten. Z.B. umfassen diese Konfigurationsinformationen
- eine Information über die Blockgröße für das Rechenwerk RW2 (Viterbi-Dekodierer),
- eine Information über die Dekodierrate für das Rechenwerk RW2,
- eine Information über die verwendeten Faltungspolynome für das Rechenwerk RW2,
- eine Information über die Größe der zu entzerrenden Teilsegmente von Empfangsdatensymbolen xₖ für das Rechenwerk RW1, etc.

Mittels der Konfigurationsinformationen werden den Hardware-Rechenwerken RW1 bzw. RW2 Angaben über die Prozessierung bzw. Verwendung der in die Speicherteilbereiche geschriebenen Daten mitgeteilt. Derartige Informationen über die Verwendung der vom DSP in die Speicherteilbereiche geschriebenen Daten betreffen z.B.
- die Größe des Speicherteilbereichs T1_RAM2 für die Soft-Input-Werte für den Dekodierer,
- die Größe des Speicherteilbereichs T0_RAM2 für die Trace-Back-Werte vom Dekodierer, die von dem DSP gelesen werden,
- die Zuordnung von Speicherplätzen im Speicherteilbereich T1_RAM2 für die Soft-Input-Werte für den Dekodierer: Es können zwei oder drei oder vier Soft-Input-Werte pro Zeiteinheit auftreten,
- die Zuordnung von Speicherplätzen im Speicherteilbereich T0_RAM2 für die von dem Dekodierer berechneten Trace-Back-Werte: Es können sechzehn (GSM) oder vierundsechzig (EDGE) Zustände pro Zeiteinheit zu berücksichtigen sein,
- die Verwendung der in dem Speicherteilbereich T1_RAM1 gespeicherten Kanalkoeffizienten sowie gegebenenfalls Produkte/Teilsummen von Kanalkoeffizienten durch das Hardware-Rechenwerk RW1,
- die Größe des Speicherteilbereichs T2_RAM2 für die Soft-Output-Werte von dem Entzerrer,
- die Größe des Speicherteilbereichs T3_RAM2 für die Hard-Output-Werte von dem Entzerrer, etc..

Die in den Konfigurationsspeicher CONFIG geschriebenen Konfigurationsdaten betreffen nicht nur den Schreibvorgang (d.h. die Übermittlung von Daten von dem DSP zu den Hardware-Rechenwerken RW1, RW2), sondern es werden auch die zur Durchführung des DSP-Lesezugriffs vorgesehenen Speicherteilbereiche entsprechend unterstützt. Dabei definiert der DSP über die in das Konfigurationsregister CONFIG geschriebenen Konfigurationsdaten z.B. die Menge der von dem DSP bei einem Lesevorgang zu lesenden Zwischenergebnisse und gegebenenfalls weitere Konfigurationsinformatonen, welche die Verarbeitung der in den Hardware-Rechenwerken RW1, RW2 berechneten und in den jeweiligen Speicherteilbereichen abgelegten Daten im DSP betreffen.

Ein weiterer Aspekt der Erfindung berücksichtigt, dass die zu übertragenden Datentypen unterschiedliche Wortbreiten und einen reellen oder komplexwertigen Wertebereich (im letztgenannten Fall sind für eine Größe zwei Datenwörter erforderlich) aufweisen können, d.h. allgemein mit einer unterschiedlichen Anzahl von Bits kodiert sind. Auf der anderen Seite sollen vorteilhafterweise kostengünstige Standard-Speicher einer fest vorgegebenen Wortbreite eines Speicherdatenwortes eingesetzt werden. Um eine möglichst gute Speicherplatzausnutzung zu erreichen, besteht die Möglichkeit zum Packen der zu übertragenden Daten (z.B. ein, zwei oder drei Datenwörter) in eine durch den Datenspeicher vorgegebene Wortbreite. Das Packen unterstützt ferner einen Mehrfach-Zugriff seitens der Hardware-Rechenwerke, z.B. können die Real- und Imaginärteile von Empfangsdatensymbolen oder auch von Zustandsmetrikwerten für benachbarte Zustände innerhalb eines Speicherdatenwortes des Datenspeichers abgelegt werden.

Die Auswahl eines Packungs- oder Entpackungsmodus durch den DSP kann in ähnlicher Weise wie die Anwahl der Basisadressen über das Setzen entsprechender Auswahlbits PC0, PC1, usw. in einem Packungs-Konfigurationsspeicher PC erfolgen, siehe Fig. 5. Zu diesem Zweck ist im Bereich der Datenbusse DB1-4 (bzw. Datenverbindung DV1) zwischen dem Eingabe/Ausgabespeicher I/O_DEC bzw. I/O_EQ und den Datenspeichern RAM1, RAMW1, RAMW2 mit einer Wortbreite von 32 Bit ein 16-Bit-Multiplexer MUX16 für das Schreiben und ein 16-Bit-Demultiplexer DMUX16 für das Lesen angeordnet. Der Multiplexer MUX16 sowie auch der Demultiplexer DMUX16 sind jeweils mit einem Zwischenspeicher für ein 16-Bit-Datenwort versehen, um beim Schreiben zwei nacheinander von dem DSP ausgegebene 16-Bit-Datenwörter zu einem 32-Bit-Speicherdatenwort zusammenzufassen, bzw. um ein 32-Bit-Speicherdatenwort in zwei vom DSP sequentiell zu verarbeitende 16-Bit-Datenwörter zu zerlegen. Entsprechende Multiplexer und Demultiplexer MUX8 und DMUX8 mit Zwischenspeichern für ein 8-Bit Datenwortabschnitt sind in dem Datenbus DB2 zum 16-Bit-Datenspeicher RAM2 angeordnet. Der Packungsmodus bewirkt hier, dass zwei vom DSP ausgegebene 16-Bit-Datenwörter, die jeweils nur 8 Bits ausnutzen (z.B. Soft-Input/Output-Werte), zu einem 16-Bit Speicherdatenwort kombiniert werden.

Bei Setzen eines Packungsmodus muss der Zähltakt des Zähler C entsprechend angepaßt und gegenüber dem Systemtakt CLK verlangsamt werden.

Es wird darauf hingewiesen, dass die Einstellung der Packungs- bzw. Entpackungsmodi nicht allein von den Wortbreiten der übertragenen Datenwörter bzw. den Wortbreiten der Speicher abhängt, sondern auch durch die Auslegung und Konfiguration des Viterbi-Rechenwerkes RW bedingt sein kann. Beispielsweise ist die Anzahl der Eingangsdatenwörter (Soft-Input-Werte) eines Dekodierers zur Durchführung einer Viterbi-Rekursion abhängig von der senderseitig gewählten Koderate (genauer werden bei einer Koderate R_{c} = 1/k eine Anzahl von k Soft-Input-Werten pro Zeitschritt im Dekodierer benötigt). Die Koderate kann in Abhängigkeit von dem gewählten Dienst variabel sein. Durch eine entsprechende, Koderaten-abhängige Packungsvorschrift kann erreicht werden, dass das Hardware-Rechenwerk RW2 für die Kanaldekodierung pro Zeitschritt auch bei unterschiedlichen Koderaten lediglich einmal auf den entsprechenden Speicherteilbereich zugreifen muss. Das Vorsehen einer Packungs- bzw. Entpackungsmöglichkeit von Datenwörtern erhöht somit in erheblichem Maße die Flexibilität des erfindungsgemäßen Datenübertragungsverfahrens, insbesondere auch im Hinblick auf die Entzerrung/Kanaldekodierung von Datensignalen unterschiedlicher Mobilfunkstandards (beispielsweise GSM und EDGE) mit derselben Hardware RW1, RW2.

Schließlich wird darauf hingewiesen, dass die im vorliegenden Beispiel beschriebene DSP-Hardware-Schnittstelle bei den Datenverbindungen 1 und 5 lediglich ein Beispiel darstellt und z.B. auch in den Datenverbindungen 2, 4 vorgesehen sein kann. In diesem Fall werden die Übergangsmetrikwerte sowie die Trace-Back-Werte in dem Prozessor DSP berechnet, während nur für die Durchführung der ACS-Operationen ein Hardware-Rechenwerk eingesetzt wird.

Sämtliche beschriebenen Ausführungsbeispiele sind kombinierbar und ihnen ist gemeinsam, dass stets eine rechenaufwandsarme und schnelle Übertragung von Daten zwischen einem digitalen Prozessor und einer Hardware-Unterstützung für den Prozessor erreicht wird.

## Patentansprüche

1. Verfahren zur Übertragung von Daten mehrerer Datentypen zwischen einem digitalen Prozessor (DSP) und einem Hardware-Rechenwerk (RW; RW1, RW2), wobei dem Hardware-Rechenwerk (RW; RW1, RW2) wenigstens ein Tabellenspeicher (SP; RAM1, RAM2, RAMW1, RAMW2) zugeordnet ist, aus welchem es während eines Rechenlaufs benötigte Daten bezieht und/oder in welches es während eines Rechenlaufs berechnete Daten ablegt, und wobei das Verfahren für Schreib- und/oder Lesezugriffen des Prozessors (DSP) auf den Tabellenspeicher (SP; RAM1, RAM2, RAMW1, RAMW2) die Schritte umfasst:
Anwahl einer Basisadresse (BA0, BA1, .., BAn) des Tabellenspeichers (SP; RAM1, RAM2, RAMW1, RAMW2), welche abhängig von dem Datentyp der zu übertragenden Daten ist, durch den Prozessor (DSP);
Zugreifen des digitalen Prozessors (DSP) auf den Tabellenspeicher (SP; RAM1, RAM2, RAMW1, RAMW2), indem ausgehend von der angewählten Basisadresse (BA0, BA1, .., BAn) mehrere für Schreib- und/oder Lesezugriffe verwendete Adressen des Tabellenspeichers (SP; RAM1, RAM2, RAMW1, RAMW2) bei aufeinanderfolgenden Zugriffen nach einer vorgegebenen arithmetischen Rechenvorschrift in Hardware berechnet werden.

2. Verfahren nach Anspruch 1,
**dadurch gekennzeichnet,**
- **dass** die den unterschiedlichen Datentypen zugeordneten Basisadressen (BA0, BA1, .., BAn) in einem Basisadressenregister (AR) abgelegt sind, und
- **dass** die Anwahl einer Basisadresse (BA0, BA1, .., BAn) durch Setzen eines dieser Basisadresse (BA0, BA1, .., BAn) zugeordneten Auswahlbits über den Prozessor (DSP) erfolgt.

3. Verfahren nach Anspruch 1 oder 2,
**dadurch gekennzeichnet,**
- **dass** die arithmetische Rechenvorschrift zur Berechnung der Adressen des Tabellenspeichers (SP) eine Inkrementierungs- bzw. Dekrementierungsvorschrift ist.

4. Verfahren nach einem der vorhergehenden Ansprüche,
**dadurch gekennzeichnet,**
**dass** die Basisadressen (BA0, BA1, ..., BAn) unveränderbar in Hardware vorgegeben sind.

5. Verfahren nach einem der Ansprüche 1 bis 3,
**dadurch gekennzeichnet,**
**dass** die Basisadressen (BA0, BA1, ..., BAn) von dem digitalen Prozessor (DSP) programmierbar sind.

6. Verfahren nach einem der vorhergehenden Ansprüche,
**dadurch gekennzeichnet,**
**dass** eine Information betreffend die Anzahl der Daten, die in die den jeweiligen Basisadressen (BA0, BA1, ..., BAn) zugeordneten Speicherteilbereiche (T1_RAM1, ..., T0_RAM2, ..., T0_RAMW1, ..., T0_RAMW2) geschrieben oder aus diesen gelesen werden und/oder eine Information über die Blockgröße von Datenblöcken und/oder eine Information über die Dekodierrate und/oder eine Information über die verwendeten Faltungspolynome von dem digitalen Prozessor (DSP) programmierbar sind.

7. Verfahren nach einem der vorhergehenden Ansprüche,
**dadurch gekennzeichnet,**
**dass** es sich bei einem ersten Datentyp um für ein Dekodierer-Hardware-Rechenwerk (RW; RW2) bestimmte Soft-Input-Werte für die Kanaldekodierung handelt, und
**dass** von dem digitalen Prozessor (DSP) programmierbar ist, wie viele Soft-Input-Werte pro Zeiteinheit in dem dem ersten Datentyp zugeordneten Speicherteilbereich (T1_RAM2) abspeicherbar sind.

8. Verfahren nach einem der vorhergehenden Ansprüche,
**dadurch gekennzeichnet,**
**dass** es sich bei einem zweiten Datentyp um von einem Dekodierer-Hardware-Rechenwerk (RW; RW2) berechnete Trace-Back-Werte handelt, und
**dass** von dem digitalen Prozessor (DSP) programmierbar ist, wie viele Zustände die Trace-Back-Werte umfassen sollen.

9. Verfahren nach einem der vorhergehenden Ansprüche, **gekennzeichnet durch** den weiteren Schritt:
- Wahl eines Packungsmodus, welcher bewirkt, dass mehrere von dem Prozessor (DSP) ausgegebene Datenwörter für einen Speicherzugriff gemäß Schritt (b) zu einem Speicherdatenwort für den Tabellenspeicher (SP; RAM1, RAM2, RAMW1, RAMW2) zusammengefasst werden, und/oder
- Wahl eines Entpackungsmodus, welcher bewirkt, dass ein mit einem Speicherzugriff gemäß Schritt (b) aus dem Tabellenspeicher (SP; RAM1, RAM2, RAMW1, RAMW2) gelesenes Speicherdatenwort vor der Eingabe in den Prozessor (DSP) in mehrere Datenwörter zerlegt wird.

10. Schaltungsanordnung zur Übertragung von Daten mehrerer Datentypen zwischen einem Prozessor (DSP) und einem Hardware-Rechenwerk (RW; RW1, RW2), wobei dem Hardware-Rechenwerk (RW; RW1, RW2) wenigstens ein Tabellenspeicher (SP; RAM1, RAM2, RAMW1, RAMW2) zugeordnet ist, aus welchem es während eines Rechenlaufs benötigte Daten bezieht und/oder in welches es während eines Rechenlaufs berechnete Daten ablegt, wobei die Schaltungsanordnung
- ein Basisadressen-Speichermittel (AR), in welchem zu jedem Datentyp eine durch den Prozessor (DSP) anwählbare Basisadresse (BA0, BA1, .., BAn) für den Tabellenspeicher (SP; RAM1, RAM2, RAMW1, RAMW2) gespeichert ist, und
- eine Hardware-Adressenberechnungsschaltung (C), welche ausgehend von einer Basisadresse (BA0, BA1, .., BAn) durch Anwenden einer arithmetischen Rechenvorschrift mehrere Adressen für aufeinanderfolgende Schreib- und/oder Lesezugriffen des digitalen Prozessors (DSP) auf den Tabellenspeicher (SP; RAM1, RAM2, RAMW1, RAMW2) in Hardware erzeugt, umfasst.

11. Schaltungsanordnung nach Anspruch 10,
**dadurch gekennzeichnet,**
- **dass** das Basisadressen-Speichermittel ein externes Basisadressenregister (AR) ist, welches derart aufgebaut ist, dass die Anwahl einer Basisadresse (BA0, BA1, .., BAn) durch Setzen eines dieser Basisadresse zugeordneten Auswahlbits (B0, B1, ..., Bn) seitens des Prozessors (DSP) erfolgt.

12. Schaltungsanordnung nach Anspruch 10 oder 11,
**dadurch gekennzeichnet,**
**dass** das Basisadressen-Speichermittel (AR) ein Festwertspeicher ist.

13. Schaltungsanordnung nach Anspruch 10 oder 11,
**dadurch gekennzeichnet,**
**dass** das Basisadressen-Speichermittel (AR) ein wiederbeschreibbarer Speicher ist, welcher von dem digitalen Prozessor (DSP) programmierbar ist.

14. Schaltungsanordnung nach Anspruch 10 bis 13,
**gekennzeichnet durch**
einen Konfigurationsspeicher (CONFIG), in welchem eine Information über die Anzahl der Daten, die in die den jeweiligen Basisadressen (BA0, BA1, ..., BAn) zugeordneten Speicherteilbereiche (T1_RAM1, ..., T0_RAM2, ..., T0_RAMW1, ..., T0_RAMW2) geschrieben oder aus diesen gelesen werden und/oder eine Information über die Blockgröße von Datenblöcken und/oder eine Information über die Dekodierrate und/oder eine Information über die verwendeten Faltungspolynome gespeichert sind.

15. Schaltungsanordnung nach Anspruch 10 bis 14,
**dadurch gekennzeichnet,**
- **dass** die Schaltungsanordnung ein Multiplexer- und Zwischenspeichermittel (MUX16, MUX8) aufweist, mittels welchem mehrere von dem Prozessor (DSP) ausgegebene Datenwörter zu einem zur Speicherung unter einer Adresse im Tabellenspeicher (SP; RAM1, RAM2, RAMW1, RAMW2) vorgesehenen Speicherdatenwort zusammengefügt werden.

16. Schaltungsanordnung nach Anspruch 10 bis 15,
**dadurch gekennzeichnet,**
- **dass** die Schaltungsanordnung ein Demultiplexer- und Zwischenspeichermittel (DMUX16, DMUX8) aufweist, mittels welchem ein aus dem Tabellenspeicher (SP; RAM1, RAM2, RAMW1, RAMW2) ausgelesenes Speicherdatenwort vor der Eingabe in den Prozessor (DSP) in mehrere Datenwörter zerlegt wird.

17. Schaltungsanordnung nach Anspruch 10 bis 16,
**dadurch gekennzeichnet,**
- **dass** der Tabellenspeicher (SP; RAM1, RAM2, RAMW1, RAMW2) eine vorgegebene Speicherwortbreite aufweist.

18. Schaltungsanordnung nach Anspruch 10 bis 17,
**dadurch gekennzeichnet,**
- **dass** es sich bei dem Hardware-Rechenwerk (RW; RW1, RW2) um ein Viterbi-Hardware-Rechenwerk handelt.

19. Schaltungsanordnung nach Anspruch 10 bis 18
**dadurch gekennzeichnet,**
- **dass** der Prozessor (DSP) mit zwei Hardware-Rechenwerken (RW1, RW2) in Datenübertragungsverbindung steht, wobei das eine Hardware-Rechenwerk ein Entzerrer-Hardware-Rechenwerk (RW1) und das andere Hardware-Rechenwerk ein Dekodierer-Hardware-Rechenwerk (RW2) ist.

## Claims

1. Method for transmitting data comprising a plurality of data types between a digital processor (DSP) and a hardware arithmetic-logic unit (RW; RW1, RW2), where the hardware arithmetic-logic unit (RW; RW1, RW2) has at least one associated table memory (SP; RAM1, RAM2, RAMW1, RAMW2) from which it obtains data required during a computing operation and/or in which it stores data computed during a computing operation, and where the method for read and/or write access operations to the table memory (SP; RAM1, RAM2, RAMW1, RAMW2) by the processor (DSP) comprises the following steps:
a base address (BA0, BA1, .., BAn) in the table memory (SP; RAM1, RAM2, RAMW1, RAMW2) which is dependent on the data type of the data which are to be transmitted is preselected by the processor (DSP);
the digital processor (DSP) accesses the table memory (SP; RAM1, RAM2, RAMW1, RAMW2) by taking the
preselected base address (BA0, BA1, .., BAn) as a
starting point for computing a plurality of addresses used for read and/or write access operations in the table memory (SP; RAM1, RAM2, RAMW1, RAMW2) for consecutive access operations according to a prescribed arithmetic computation rule in hardware.

2. Method according to Claim 1,
**characterized**
- **in that** the base addresses (BA0, BA1, .., BAn) associated with the different data types are stored in a base address register (AR), and
- **in that** a base address (BA0, BA1, .., BAn) is preselected by setting a selection bit associated with this base address (BA0, BA1, .., BAn) using the processor (DSP).

3. Method according to Claim 1 or 2,
**characterized**
- **in that** the arithmetic computation rule for computing the addresses in the table memory (SP) is an incrementation or decrementation rule.

4. Method according to one of the preceding claims,
**characterized**
**in that** the base addresses (BA0, BA1, ..., BAn) are prescribed unalterably in hardware.

5. Method according to one of Claims 1 to 3,
**characterized**
**in that** the base addresses (BA0, BA1, ..., BAn) can be programmed by the digital processor (DSP).

6. Method according to one of the preceding claims,
**characterized**
**in that** information relating to the number of data items which are written to or read from the memory subareas (T1_RAM1, ..., T0_RAM2, ..., T0_RAMW1, ..., T0_RAMW2) associated with the respective base addresses (BA0, BA1, ..., BAn) and/or information about the block size of data blocks and/or information about the decoding rate and/or information about the convolution polynomials used can be programmed by the digital processor (DSP).

7. Method according to one of the preceding claims,
**characterized**
**in that** a first data type is soft input values for the channel decoding which are intended for a decoder hardware arithmetic-logic unit (RW; RW2), and
**in that** the digital processor (DSP) is able to program how many soft input values per unit time can be stored in the memory subarea (T1_RAM2) associated with the first data type.

8. Method according to one of the preceding claims,
**characterized**
**in that** a second data type is trace back values computed by a decoder hardware arithmetic-logic unit (RW; RW2), and
**in that** the digital processor (DSP) is able to program how many states the trace back values need to comprise.

9. Method according to one of the preceding claims,
**characterized by** the following further step:
- a packing mode is chosen which causes a plurality of data words output by the processor (DSP) for memory access in line with step (b) to be combined to form a memory data word for the table memory (SP; RAM1, RAM2, RAMW1, RAMW2), and/or
- an unpacking mode is chosen which causes a memory data word read from the table memory (SP; RAM1, RAM2, RAMW1, RAMW2) upon memory access in line with step (b) to be broken down into a plurality of data words before input into the processor (DSP).

10. Circuit arrangement for transmitting data comprising a plurality of data types between a processor (DSP) and a hardware arithmetic-logic unit (RW; RW1, RW2), where the hardware arithmetic-logic unit (RW; RW1, RW2) has at least one associated table memory (SP; RAM1, RAM2, RAMW1, RAMW2) from which it obtains data required during a computing operation and/or in which it stores data computed during a computing operation, the circuit arrangement comprising
- a base address memory means (AR) which stores, for each data type, a base address (BA0, BA1, .., BAn), preselectable by the processor (DSP), for the table memory (SP; RAM1, RAM2, RAMW1, RAMW2), and
- a hardware address computation circuit (C) which, taking a base address (BA0, BA1, .., BAn) as a starting point, applies an arithmetic computation rule in order to produce a plurality of addresses for consecutive read and/or write access operations to the table memory (SP; RAM1, RAM2, RAMW1, RAMW2) by the digital processor (DSP) in hardware.

11. Circuit arrangement according to Claim 10,
**characterized**
- **in that** the base address memory means is an external base address register (AR) which is designed such that a base address (BA0, BA1, .., BAn) is preselected by virtue of the processor (DSP) setting a selection bit (B0, B1, ..., Bn) associated with this base address.

12. Circuit arrangement according to Claim 10 or 11,
**characterized**
**in that** the base address memory means (AR) is a read only memory.

13. Circuit arrangement according to Claim 10 or 11,
**characterized**
**in that** the base address memory means (AR) is a rewritable memory which can be programmed by the digital processor (DSP).

14. Circuit arrangement according to Claim 10 to 13,
**characterized by** a configuration memory (CONFIG) which stores information about the number of data items which are written to or read from the memory subareas (T1_RAM1, ..., T0_RAM2, ..., T0_RAMW1, ..., T0_RAMW2) associated with the respective base addresses (BA0, BA1, ..., BAn) and/or information about the block size of data blocks and/or information about the decoding rate and/or information about the convolution polynomials used.

15. Circuit arrangement according to Claim 10 to 14,
**characterized**
- **in that** the circuit arrangement has a multiplexer and buffer means (MUX16, MUX8) which is used to assemble a plurality of data words output by the processor (DSP) to form a memory data word which is intended for storage at an address in the table memory (SP; RAM1, RAM2, RAMW1, RAMW2).

16. Circuit arrangement according to Claim 10 to 15,
**characterized**
- **in that** the circuit arrangement has a demultiplexer and buffer means (DMUX16, DMUX8) which is used to break down a memory data word read from the table memory (SP; RAM1, RAM2, RAMW1, RAMW2) into a plurality of data words before input into the processor (DSP).

17. Circuit arrangement according to Claim 10 to 16,
**characterized**
- **in that** the table memory (SP; RAM1, RAM2, RAMW1, RAMW2) has a prescribed memory word length.

18. Circuit arrangement according to Claim 10 to 17,
**characterized**
- **in that** the hardware arithmetic-logic unit (RW; RW1, RW2) is a Viterbi hardware arithmetic-logic unit.

19. Circuit arrangement according to Claim 10 to 18,
**characterized**
- **in that** the processor (DSP) has a data transmission connection to two hardware arithmetic-logic units (RW1, RW2), with one hardware arithmetic-logic unit being an equalizer hardware arithmetic-logic unit (RW1) and the other hardware arithmetic-logic unit being a decoder hardware arithmetic-logic unit (RW2).

## Revendications

1. Procédé de transmission de données de plusieurs types entre un processeur numérique (DSP) et une unité de calcul matérielle (RW ; RW1, RW2), au moins une mémoire de tables (SP ; RAM1, RAM2, RAW1, RAW2) étant associée à l'unité de calcul matérielle qui y cherche les données nécessaires pendant une opération de calcul et/ou qui y mémorise les données calculées pendant une opération de calcul, et le procédé comportant, en vue de l'accès en lecture et/ou en écriture du processeur (DSP) à la mémoire de tables (SP ; RAM1, RAM2, RAW1, RAW2), les étapes consistant à :
- sélectionner une adresse de base (BA0, BA1, ..., BAn), dépendant du type des données à transmettre, de la mémoire de tables (SP ; RAM1, RAM2, RAW1, RAW2) au moyen du processeur (DSP) ;
- permettre au processeur numérique (DSP) d'accéder à la mémoire de tables (SP ; RAM1, RAM2, RAW1, RAW2) en calculant sous forme matérielle, suivant une règle de calcul arithmétique prescrite, plusieurs adresses, utilisées pour les accès en écriture et/ou en lecture, de la mémoire de tables (SP ; RAM1, RAM2, RAW1, RAW2) lors d'accès successifs à partir de l'adresse de base sélectionnée (BA0, BA1, ..., BAn).

2. Procédé selon la revendication 1, **caractérisée en ce que**
- les adresses de base (BA0, BA1, ..., BAn), associées aux différents types de données, sont mémorisées dans un registre d'adresses de base (AR), et
- la sélection d'une adresse de base (BA0, BA1, ..., BAn) est effectuée en initialisant un bit de sélection, associé à cette adresse de base (BA0, BA1, ..., BAn), à l'aide du processeur (DSP).

3. Procédé selon la revendication 1 ou 2, **caractérisé en ce que** la règle de calcul arithmétique permettant de calculer les adresses de la mémoire de tables (SP) est une règle d'incrémentation respectivement de décrémentation.

4. Procédé selon l'une des revendications précédentes, **caractérisé en ce que** les adresses de base (BA0, BA1, ..., BAn) sont prescrites comme invariables sous forme matérielle.

5. Procédé selon l'une des revendications 1 à 3, **caractérisé en ce que** les adresses de base (BA0, BA1, ..., BAn) sont programmables par le processeur numérique (DSP).

6. Procédé selon l'une des revendications précédentes, **caractérisé en ce qu'**une information sur le nombre de données, qui sont écrites dans les zones de mémoire (T1_RAM1, ..., T0_RAM2, ..., T0_RAMW1, ..., T0_RAMW2) associées aux adresses de base respectives (BA0, BA1, ..., BAn) ou qui sont lues dans ces zones de mémoire et/ou une information sur la taille des blocs de données et/ou une information sur le taux de décodage et/ou une information sur les polynômes de convolution utilisés sont programmables par le processeur numérique (DSP).

7. Procédé selon l'une des revendications précédentes,
**caractérisé en ce que**
- un premier type de données est constitué par des valeurs Soft-Input déterminées pour une unité de calcul matérielle de décodage (RW ; RW2) pour le décodage de canal, et
- on peut programmer au moyen du processeur numérique (DSP) combien de valeurs Soft-Input par unité de temps peuvent être mémorisées dans la zone de mémoire (T1_RAM2) associée au premier type de données.

8. Procédé selon l'une des revendications précédentes,
**caractérisé en ce que**
- un deuxième type de données est constitué par des valeurs Trace-Back calculées par une unité de calcul matérielle de décodage (RW ; RW2), et
- on peut programmer au moyen du processeur numérique (DSP) combien d'états peuvent prendre les valeurs Trace-Back.

9. Procédé selon l'une des revendications précédentes, **caractérisé par** l'étape supplémentaire consistant à :
- sélectionner un mode de compression ayant pour but d'assembler plusieurs mots de données, délivrées par le processeur (DSP), pour un accès mémoire selon l'étape (b) pour donner un mot de données de mémoire pour la mémoire de tables (SP ; RAM1, RAM2, RAW1, RAW2), et/ou
- sélectionner un mode de décompression ayant pour but de décomposer en plusieurs mots de données un mot de données de mémoire lu dans la mémoire de tables (SP ; RAM1, RAM2, RAW1, RAW2) avec un accès mémoire selon l'étape (b), avant l'entrée dans le processeur (DSP).

10. Circuit de transmission de données de plusieurs types entre un processeur numérique (DSP) et une unité de calcul matérielle (RW ; RW1, RW2), au moins une mémoire de tables (SP ; RAM1, RAM2, RAW1, RAW2) étant associée à l'unité de calcul matérielle (RW ; RW1, RW2) qui y cherche les données nécessaires pendant une opération de calcul et qui y mémorise les données calculées pendant une opération de calcul, le circuit comportant :
- un moyen de mémorisation d'adresses de base (AR) dans lequel, pour chaque type de données, une adresse de base (BA0, BA1, ..., BAn), sélectionnable par le processeur (DSP), pour la mémoire de tables (SP ; RAM1, RAM2, RAW1, RAW2), et
- un circuit de calcul d'adresses matériel (c) qui génère à partir d'une adresse de base (BA0, BA1, ..., BAn), en utilisant une règle de calcul arithmétique, plusieurs adresses pour des accès successifs en écriture et/ou en lecture du processeur numérique (DSP) à la mémoire de tables (SP ; RAM1, RAM2, RAW1, RAW2).

11. Circuit selon la revendication 10, **caractérisé en ce que**
- le moyen de mémoire d'adresses de base est un registre d'adresse de base externe (AR) qui effectue la sélection d'une adresse de base (BA0, BA1, ..., BAn) en initialisant un bit de sélection (B0, B1, ..., Bn), associé à cette adresse de base, au moyen du processeur (DSP).

12. Circuit selon la revendication 10 ou 11, **caractérisé en ce que** le moyen de mémoire d'adresses de base (AR) est une mémoire à lecture seule.

13. Circuit selon la revendication 10 ou 11, **caractérisé en ce que** le moyen de mémoire d'adresses de base (AR) est une mémoire dans laquelle on peut écrire à nouveau et qui est programmable par le processeur numérique (DSP).

14. Circuit selon la revendication 10 à 13, **caractérisé par** une mémoire de configuration (CONFIG) dans laquelle sont mémorisées une information sur le nombre de données, qui sont écrites dans les zones de mémoire (T1_RAM1, ..., T0_RAM2, ..., T0_RAMW1, ..., T0_RAMW2) associées aux adresses de base respectives (BA0, BA1, ..., Ban) ou qui sont lues dans ces zones de mémoire et/ou une information sur la taille des blocs de données et/ou une information sur le taux de décodage et/ou une information sur les polynômes de convolution utilisés.

15. Circuit selon la revendication 10 à 14, **caractérisé en ce que** le circuit comporte un moyen de multiplexage et de mémorisation temporaire (MUX16, MUX8) permettant d'assembler plusieurs des mots de données délivrés par le processeur (DSP) en un mot de données de mémoire prévu pour la mémorisation à une adresse dans la mémoire de tables (SP ; RAM1, RAM2, RAW1, RAW2).

16. Circuit selon la revendication 10 à 15, **caractérisé en ce que** le circuit comporte un moyen de démultiplexage et de mémorisation temporaire (DMUX16, DMUX8) permettant de décomposer un mot de données de mémoire lu dans la mémoire de tables (SP ; RAM1, RAM2, RAW1, RAW2) en plusieurs mots de données avant l'entrée dans le processeur (DSP).

17. Circuit selon la revendication 10 à 16, **caractérisé en ce que** la mémoire de tables (SP ; RAM1, RAM2, RAW1, RAW2) a une largeur de mot de mémoire prescrite.

18. Circuit selon la revendication 10 à 17, **caractérisé en ce que** l'unité de calcul matérielle (RW ; RW1, RW2) est une unité de calcul matérielle Viterbi.

19. Circuit selon la revendication 10 à 18, **caractérisé en ce que** le processeur (DSP) est en liaison de transmission de données avec deux unités de calcul matérielle (RW1, RW2), l'une des unités de calcul matérielle étant une unité de calcul matérielle de décomposition (RW1) et l'autre unité de calcul matérielle étant une unité de calcul matérielle de décodage (RW2)
